(19) Europäisches Patentamt / European Patent Office / Office européen des brevets

(11) **EP 2 402 999 A1**

(12) **EUROPEAN PATENT APPLICATION**

(43) Date of publication:
**04.01.2012 Bulletin 2012/01**

(51) Int Cl.:
***H01L 29/786*** (2006.01)

(21) Application number: **10167703.7**

(22) Date of filing: **29.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **IHP GmbH-Innovations for High Performance Microelectronics / Leibniz-Institut für innovative Mikroelektronik**
**15236 Frankfurt / Oder (DE)**

(72) Inventors:
• **Lippert, Gunther**
**15236 Frankfurt (Oder) (DE)**

• **Lupina, Grzegorz**
**10247 Frankfurt (Oder) (DE)**
• **Seifarth, Olaf**
**15230 Frankfurt (Oder) (DE)**
• **Zöllner, Marvin**
**15232 Frankfurt (Oder) (DE)**
• **Thieme, Hans-Joachim**
**15236 Pillgram (DE)**

(74) Representative: **Eisenführ, Speiser & Partner**
**Anna-Louisa-Karsch-Strasse 2**
**10178 Berlin (DE)**

(54) **Semiconductor component, method of producing a semiconductor component, semiconductor device**

(57) Semiconductor component comprising:
- a silicon containing layer (1),
- at least one graphene layer (3, 3', 3", 3'''), and
- a functional layer (2, 2', 2", 2''') between the silicon containing layer (1) and the graphene layer (3, 3', 3", 3'''), wherein
the at least one graphene layer (3', 3", 3''') is deposited directly on the functional layer (2, 2', 2", 2''') to form a layer system (6, 6', 6", 6''') with the functional layer (2, 2', 2", 2'''), and
the functional layer (2, 2', 2", 2''') includes at least one dielectric material having a dielectric constant k in a range between K=3 to K=400, and
a conductance of the functional layer (2, 2', 2", 2''') in the layer system (6, 6', 6", 6''') is below a conductance of the graphene layer (3, 3', 3", 3''').

**FIG. 1a**

1 Si-Substrate

2.1 Ti-Nitride

Ti 10

EP 2 402 999 A1

1 Si-Substrate
2.1 Ti-Nitride
2.2 HF-Oxide

21 Oxygen

Hf ~20

**FIG. 1b**

1 Si-Substrate
2.1 Ti-Nitride
2.2 HF-Oxide
2.3 Barium

Ba ~30

**FIG. 1c**

1 Si-Substrate
2 BaHfTiO$_3$-layer

RTA to homogenize

**FIG. 1d**

1 Si-Substrate
2 BaHfTiO$_3$-layer
6
3 Graphene

C$_3$H$_6$

UV + RTA to catalyze

**FIG. 1e**

## Description

The invention relates to a semiconductor component comprising a silicon containing layer and a graphene layer. The invention also relates to a method of producing a semiconductor component by providing a silicon containing layer and depositing a graphene layer on the silicon containing layer. The invention also relates to a semiconductor device.

Graphene is known as a flat monolayer of carbon atoms tightly packed into a two-dimensional honeycomb structure. While graphene can be stacked into three-dimensional graphite, also graphene can be used as a basic building block for graphitic materials of reduced dimensionalities. It has been shown that graphene can be wrapped up into zero-dimensional fullerenes or rolled into one dimensional nanotubes. As single carbon layer of the graphitic structure can be considered as the final member of the series naphthalene, anthracen, coronene etc. while the graphene in the present application should be understood to designate an individual crystalline carbon layer.

Theoretical properties of graphene have been described by P. R. Wallace et al. in "The Band Theory of Graphite" in PR Vol. 71, pages 622 - 634 (1947). Due to its extraordinarily enhanced conductivity like for instance shown by Banerjee et al. in APL 88, 062111 (2006) graphene has become a promising material for future electronic devices. Experimental results from transport measurements show that graphene has remarkable high charge carrier mobility even at room temperature. A specific resistivity of a graphene layer should be in the range of $10^{-6}$ $\Omega$ cm which is less than the resistivity of silver, the lowest resistivity substance known at room temperature. However, for graphene on a silicon dioxide substrate scattering of electrons by optical phonons of the substrate generally becomes dominant and is a larger effect at room temperature than scattering by graphene's own phonons. Therefore, mobility and conductance of graphene in a layer system is reduced.

The most popular approaches to graphene preparation are mechanical exfoliation, growth on metals and subsequent graphene transfer to insulating substrates, and thermal decomposition of SiC to produce so-called epitaxial graphene on top of SiC wafers.

As a result growth of graphene is a field of actual research to overcome the above mentioned limitations as best described by Frank Schwierz in nature nanotechnology DOI 10.1038/NNANO.2010.89 with online-publication of 30.5.2010.

Exfoliation is still popular for laboratory use but it is not suited to the electronics industry, whereas the other two options both have the potential for producing wafer-scale graphene.

Attempts based on SiC in principle suffer from the small bandgap of SiC and the comparingly high temperatures necessary.

Attempts based on metal substrates are desirable due to the catalytic function of the metal but this configuration can result in a short circuit between the active graphene layer and substrate due to the high conductivity of the metal. Consequently a transfer from the metal substrate is necessary to overcome the short circuit disadvantage.

Other methods have to rely on graphene growth on a catalytic substrate (e.g. Ni) and subsequent transfer of a graphene film to a silicon substrate like reported by Kim et al. in Nature Vol. 457, page 706 - 710 (2009) or by Reina et al. in NanoRes, page 509 - 516 (2009) or by Quingkai et al. in APL Vol.93, 113103 (2008). The transfer is -like exfoliation methods- highly impracticable for large scale technical applications.

Theoretical assumptions have shown that graphene would be extremely well suitable in particular for high frequency applications in transistor technology like for instance described in US 2008/0246023 A1 or by Liang et al. in JAP Vol. 102, 054307 (2007) or by Zhang et al. in IEEE Electron Device Letters 0741-3106 (2008).

However, up to date efforts for epitaxial graphene growth on silicon containing layers or substrates are still to be improved. In particular, besides SiC, no report has been given related to growth of graphene on an isolator. This is where the invention comes in, the object of which is to specify a semiconductor component comprising a silicon containing layer and a graphene layer and also to specify a method of producing a semiconductor component wherein at least one graphene layer can be epitaxially grown on the silicon containing layer. In particular it is an object of the present invention to overcome the imperfections of state of the art growth methods for graphene. In particular it is an object of the present invention to provide a semiconductor component and a method offering the possibility of direct graphene growth on an isolator or semiconductor at compatible parameters of contemporary growth technology. In particular temperature growth parameters should be acceptable. A potential for future wafer sized grapheme growth should be achievable. In particular it is an object of the present invention to provide an epitaxial grown semiconductor component wherein an epitaxially grown graphene layer is implementable within a CMOS standard.

As relates the semiconductor component the object is achieved by a semiconductor component in accordance with the features of claim 1.

The invention provides a semiconductor component comprising:

- a silicon containing layer,
- at least one graphene layer, and
- a functional layer between the silicon containing layer and the graphene layer,

wherein
the at least one graphene layer is deposited directly on the functional layer to form a layer system with the functional layer, and
the functional layer includes at least one dielectric material having a dielectric constant k in a range between K=3 to K=1000, in particular in a range between K=3 to K=400, and
a conductance of the functional layer in the layer system is below a conductance of the graphene layer.

Preferably, the functional layer has an overall dielectric constant in a range between 3 to 1000, in particular in a range between 3 to 400. Preferably, the dielectric constant of the functional layer basically corresponds to the dielectric constant of the dielectric material or averages according to the mixture of dielectric materials. Preferably the functional layer includes a predominant fraction of at least one dielectric material. In particular the functional layer consists of the at least one dielectric material having the dielectric constant. As relates the method of producing a semiconductor component the object is achieved by a method comprising the steps as claimed in claim 13.

The main concept of the invention is based on providing a functional layer between the silicon containing layer and at least one graphene layer wherein the at least one graphene layer is deposited directly on the functional layer to form a, preferably double, layer system with the functional layer. It has been realised that the functional layer is able to form a buffer between the silicon containing layer and the graphene layer and can also be arranged with a surfactant functionality. On the one hand catalytic and reactivity properties are such that graphene bonds to the functional layer by appropriate Van-der-Waals-like forces. This means carbon from a vapour or beam or a C-transporting precursor gas is suitably cracked and is able to cover the functional layer. Also this means in particular that a C-layer is not bonded chemically or otherwise too tight to the functional layer, but the functional layer truly builds a buffer between the silicon containing material and the graphene layer such that the graphene layer is able to build up its own structure with rather minor or neglectable influence of the silicon containing layer. Also, advantageously, the dielectric material of the functional layer of the invention can show up particular preferable surfactant peroperties which can support the growth of graphene thereon.

On the other hand mobility and resistivity properties are arranged such that the, in particular double, layer system of the at least one functional layer and the at least one graphene layer is suitable to be used in an electronic application, e.g. in a capacitance unit of a semiconductor device like a transistor or a capacitance or the like or in a control unit.

Van-der-Waals-like forces are meant mainly to relate to Van-der-Waals-forces but are not restricted thereto. In particular the so called Van-der-Waals-like forces can in principle embrace also all kind of weak forces which are less strong than a covalent force, like also ionic or electrostatic forces or partially covalent forces. In particular a dielectric material exhibiting a Van-der-Waals-like force for graphene to grow on a silicon containing layer is a material for which -when applied according to the invention- a graphene binding energy to the substrate E(C-Substrate) is lower than a covalent carbon-carbon binding energy E(C-C), i.e.:

$$[E(C\text{-}C)] \, / \, [E(C\text{-}Substrate)] \geq 1$$

In the following such kind of weak forces are generally referred to as Van-der-Waals-like forces keeping in mind the broader scope extending beyond pure Van-der-Waals forces.

As compared to common place known measures the proposed concept allows to deposit a graphene layer directly on the functional layer to build the layers system of the invention provides a good compromise between the above mentioned catalytic/reactivity properties on the one hand and the mobility/resistivity properties on the other hand. To achieve such compromise as a first measure the concept of the invention proposes a functional layer including at least one dielectric material having a dielectric constant K in between K=3 to K=1000, in particular in between K=3 to K=400.

It has been shown that such kind of dielectric material implements a good compromise between insulating and metallic layer properties and also is able to provide suitable Van-der-Waals-like forces for binding of a graphene layer directly on the functional layer.

Also the concept of the invention provides a conductance of the functional layer in the layer system below a conductance of the graphene layer. Thereby any short circuit or bypass current to the graphene layer is omitted or at least reduced.

In a particular embodiment the equation holds true:

$$\Omega\_graphene * D\_graphene > \Omega\_functional\text{-}layer * D\_ functional\text{-}layer$$

wherein D is the geometrical layer thickness und $\Omega$ is the resistivity of the respective materials. The aforementioned properties of conductance in particular relate to an inplane conductance of a double layer system, i.e. with the graphene layer bonded to the functional layer.

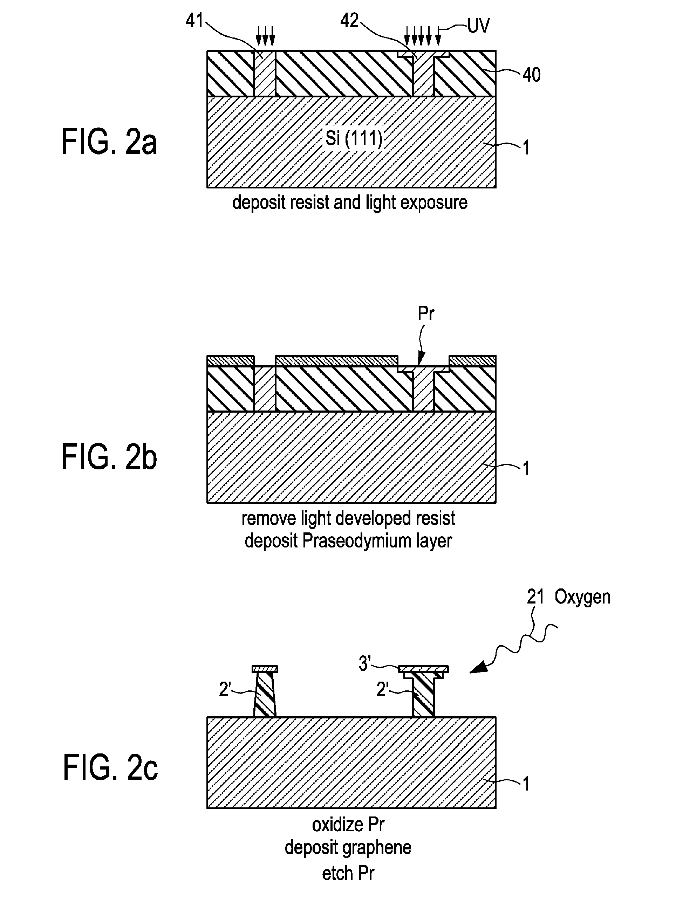

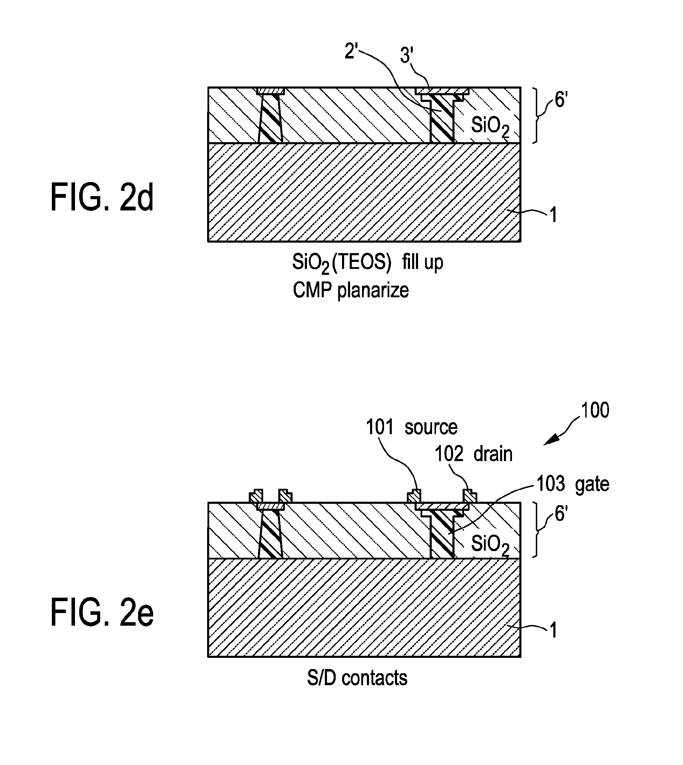

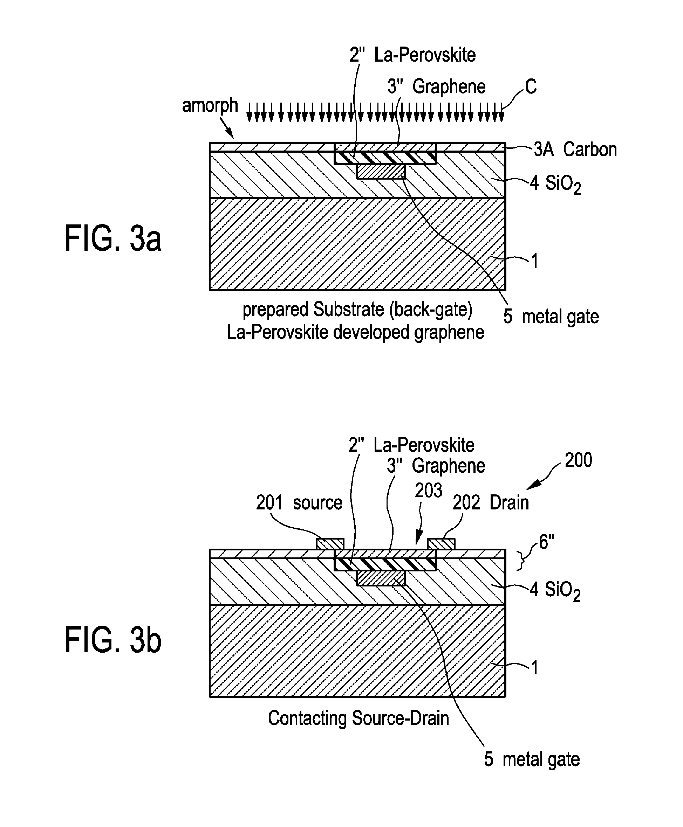

In a particular continuingly developed configuration of the semiconductor component the silicon containing layer is a silicon substrate and the functional layer is deposited directly on the silicon containing layer. The functional layer and/or the at least one graphene layer is preferably embedded in an isolating oxide material like for instance silicon oxide. Such block of layers is preferably suitable to be implemented in a transistor for instance as a gate capacitance or the like as shown in embodiments of Fig. 2 and Fig.3.

As a result, the invention provides a semiconductor component with an epitaxial grown graphene layer on a silicon containing layer with the functional layer in between. The semiconductor component can readily be implemented as a capacitive component in a semiconductor device like a capacitance or transistor device. In particular, an implementation as a gate capacitance in a transistor has been found to be readily applicable within the concept of the invention. In particular an implementation of the instantly claimed semiconductor component in a semiconductor device as described in the filed not yet published German Patent Application DE 10 2008 055 100.7 or filed but not yet published PCT Application PCT/EP2009/066958 has been found to be advantageously possible. The disclosure of DE 10 2008 055 100.7 and PCT/EP2009/066958 herewith is incorporated by reference to the disclosure of the instant application in particular for description of a preferred embodiment of a semiconductor device.

As relates the method of the invention a semiconductor component can be produced by the steps of:

- providing a silicon containing layer;

  - depositing a functional layer on the silicon containing layer by one or more functional layer-depositing steps, wherein at least one dielectric material having a dielectric constant K in between K=3 to K=1000, in particular in between K=3 to K=400, is deposited;
  - directly depositing at least one graphene layer on the functional layer by one or more graphene layer-depositing steps to form a layer system consisting of the functional layer and the graphene layer, wherein a conductance of the functional layer is below a conductance of the graphene layer.

Preferably the functional layer-depositing steps can also comprise:

- depositing the dielectric material of the functional layer and adding an additive in form of an adhesion material and/or a catalytic material and/or a surfactant or seed-material.

Preferably the functional layer-depositing steps and/or the graphene layer-depositing steps can be performed by one or more CVD and/or MBEsteps. Preferably the functional layer- and/or the graphene layer- depositing steps comprise: an annealing and/or a homogenizing step, in particular a rapid thermal annealing step.

Preferably the graphene layer depositing steps can be performed by one or more atomic layer deposition (ADL) steps. In particular preferred is the deposition of graphene by means of a carbon vapour deposition.

Either a semiconductor component as defined above or a semiconductor component produced according to the above method can be readily implemented into a semiconductor device, in particular as a capacitive component like a capacitance or a gate capacitance in a transistor.

Further developed configurations of the invention are further outlined in the dependent claims. Thereby the mentioned advantages of the proposed concept are even more improved.

In a first preferred variant of a developed configuration the functional layer is formed from a functional layer stack. Preferably the functional layer stack includes further one or more layers like an adhesion layer, a catalytic layer and a surfactant- and/or seed layer wherein these layers can be deposited each separately or in suitable combination of two or three layers one after the other directly on the silicon containing layer. Consequently each layer of the functional layer stack is able to provide a preferred function like adhesion to silicon containing layer, catalytic action to the C-providing source (e.g. e precursor gas) and a surfactant function for supporting a binding of C or C-comprising chemical formations in a Van-der Waals-like binding force. In particular also a functional layer stack - be that it may a single, some or all of the above layers - can be transformed to from a single layer of dielectric material e.g. by annealing, baking or the like heat treatment. Preferably a dielectric constant can be assigned overall to the single layer and is in a range between 3 to 1000, preferably between 3 to 400. Preferably the dielectric constant of the functional layer basically corresponds to the dielectric constant of the dielectric material or averages according to a mixture of dielectric materials. Preferably the functional layer includes a predominant fraction of at least one dielectric material or consists of the at least one dielectric material. Preferably the functional layer further includes a, in particular minor, fraction of an additive. An additive can be in form of an adhesion material and/or a catalytic material and/or a surfactant- or seed-material.

In a second additional or alternative variant of a developed configuration it is preferred also to provide the functional layer as a single or other number of layers. In a method of producing it is preferred to deposit one or more, in particular a single, layer of dielectric material. Therein an adhesion material and/or a catalytic material and/or a seed or surfactant-material can be included in the functional layer by an additive or the like. Particular preferred is a functional layer in form of a single layer of dielectric material which as such has the adhesion, catalytic and surfactant properties suitable for depositing the graphene layer. According to the concept of the invention the dielectric material having a dielectric concept K in between K=3 to K=1000, in particular in between K=3 to K=400, is suitable to function as a material of best compromise.

It turned out to be a major problem of a preferred configuration to provide a functional layer material forming a sensitive compromise between catalytic properties on the one hand and resistivity properties on the other hand. While pure metallic materials like Pt, Rh, Ni, Cr, Pr, La, Fe as such have good catalytic properties, these are not suitable to provide a sufficient resistance to a graphene layer and readily lead to a short circuit wherein bypass-currents will flow. On the other hand insulating materials other than proposed by the invention turned out to have less catalytic properties and consequently do not allow a weak binding of a graphene layer to the functional layer. However, in a preferred developed configuration it turned out that a dielectric material having a dielectric constant between K=3 to K=1000, in particular in between K=3 to K=400, have particular preferred properties for catalyzing a deposition of a graphene layer on the one hand and also forming a sufficient resistivity for forming an electronic application like a capacitance or the like in a semiconductor device.

Preferred materials of the developed configuration in particular include a dielectric material as an oxide or a nitride or a silicid or a nitrate or a silicate of an element selected from an alkaline or an alkaline earth or a rare earth or a transition metal or mixtures thereof. In particular an oxide or a nitride or a silicide or a nitrate or a silicate of an element selected from: Pr, Ce or Hf, Zr, Ti or Ba, Sr or Fe, Al, Mg, K or mixtures thereof turned out to be good dielectric materials in a functional layer. The alkaline or alkaline earth or rare earth or transition metals or the elements mentioned above can in particular be provided in different oxidation states. As a particular preferred dielectric material Ba, Hf, Ti, $O_3$ or a La-Perovskit or a chalkogenide or mixtures thereof have been shown. Also $Ce_2O_3$, $CeO_2$ or $PrO_3$ or $HfO_2$ turned out to be good candidates.

Chalcogenides are chemical compounds consisting of at least one chalcogen ion and at least one more electropositive element. Although all group 16 elements of the periodic table are defined as chalcogenides, here the term is particularly used for sulfides, se-lenides, and tellurides, rather than oxides. As solid state materials these preferably exhibit a good compromise between ionic and covalent binding forces and therefore are preferably suitable to provide a surfactant function to the functional layer be that it may to form the functional layer or a as an additive in the functional layer. In particular Chalcogenides of Ga, In, Cd, Hg, Sn, Zn, As, Ge are preferred.

In particular, a first group of high-K dielectric materials of the functional layer, like a La-Perovskit or the like, with a dielectric constant K in between K=40 to K=400, in particular in between K=60 to K=120, in particular in between K=70 to K=90, in particular in between K=75 to K=85 has shown up to be suitable.

A second group of mid-K dielectric materials of the functional layer - like e.g. Ceriumoxide (e.g. $Ce_2O_3$) or Praseodymiumoxide (e.g. $PrO_3$) or Hafniaoxide (e.g.HfO) - with a dielectric constant in between K=12 to K=40, in particular in between K=15 to K=30, in particular in between K=17 to K=25 turned out to be suitable.

Preferably a third group of low-K dielectric material of the functional layer has a K of K=3 to K=15, in particular in between K=4 to K=12. Mica has turned out to be a good candidate. In particular the dielectric material is preferably a sheet silicate mineral material, in particular silicate of the mica-group, in particular selected from the group of mica materials consisting of: phlogopite, biotite, zinnwaldite, lepidolite, muscovite. Chemically, micas can be given the general formula

X2Y4-6Z8O20(OH,F)4 or X2Y4-6Z8O10(OH,F)4

in which X is K, Na, or Ca or less commonly Ba, Rb, or Cs;

Y is Al, Mg, or Fe or less commonly Mn, Cr, Ti, Li, etc.;

Z is chiefly Si or Al but also may include Fe3+ or Ti.

Structurally, micas can be classed as dioctahedral (Y = 4) and trioctahedral (Y = 6). If the X ion is K or Na the mica is a common mica whereas if the X ion is Ca the mica is classed as a brittle mica. Mica generally defines no structural condition for the growth of grapheme, however, in preferred embodiments like $KAl_2(AlSi_3O_{10})(F,OH)$ is hexagonal oriented.

Preferably the silicon containing material and/or the dielectric material is a layered silicate material like e.g. a mica material.

It is particular preferred that the functional layer material is of crystalline, in particular cubic or preferably hexagonal structure.

The functional layer stack as best has a EOT-value (equivalent oxide thickness), which is dielectrically equivalent to the thickness of $SiO_2$ wherein the $SiO_2$-thickness is in the range between 0.5 nm and 25 nm, in particular between 1 nm and 20 nm, preferably below 15 nm.

In particular the graphene layer has an EOT-value (equivalent oxid thickness) defined by the graphene layer thickness multiplied by the dielectric constant K of the graphene of the graphene layer and wherein the functional layer EOT-value is lower as compared to the EOT-value of $SiO_x$ wherein $0 \leq x \leq 2$ and wherein a $SiO_x$-thickness is in the range between 0.5nm and 20nm.

The functional layer and/or the graphene layer is, in particular laterally, embedded in an isolating oxide material, in particular $SiO_x$ wherein $0 \leq x \leq 2$. This allows implementation into a semiconductor device in a particular advantageous way.

These and other aspects of the invention will be apparent from and elucidated with reference to the preferred embodiments described hereinafter. It is of course not possible to describe every conceivable configuration of the components or methodologies for purposes of describing the present invention but one of ordinary skill in the art will recognise that many further combinations and permutations of the present invention are possible. The techniques described above apply in particular for electronic control elements but also capacitance are capacite elements in transistors. In particular the semiconductor component can be implemented for providing a channel in a transistor and its insulator. Whereas the invention has particular utility for and will be described as associated with a MOSFET it should be understood that the concept of the invention is also operable with other forms of semiconductor devices using a capacite semiconductor component as claimed in the claims.

For a more complete understanding of the invention reference is made to the accompanying drawing. The detailed description will illustrate and describe, what is considered as a preferred embodiment of the invention. It should of course be understood, that various modifications and changes in form or detail could readily be made without departing from the spirit of the invention. It is therefore intended that the invention may not be limited to the exact form and detail shown and described herein nor to anything less than the whole of the invention disclosed herein and as claimed hereinafter. Further the features described in the description, the drawing and the claims disclosing the invention may be essential for the invention considered alone or in combination.

The drawing shows in:

Fig. 1 a first embodiment of a method of producing a semiconductor component by using a soft-tuning step for tuning the metal-isolator properties of a BaHfTiO3-layer for enforcing a catalytic function of the insulating layer;

Fig. 2 a second embodiment of a method of producing a semiconductor component with formation of a semiconductor transistor device;

Fig. 3 a third embodiment of a method of producing a semiconductor component with formation of a semiconductor transistor device;

Fig. 4. a fourth embodiment of a method of producing a semiconductor component with format of a semiconductor component using a silicate substrate as a silicon containing layer for direct (van der Waals) growth of one or more graphene layers;

Fig. 5 Raman spectra of the semiconductor component produced by the method of Fig. 4.

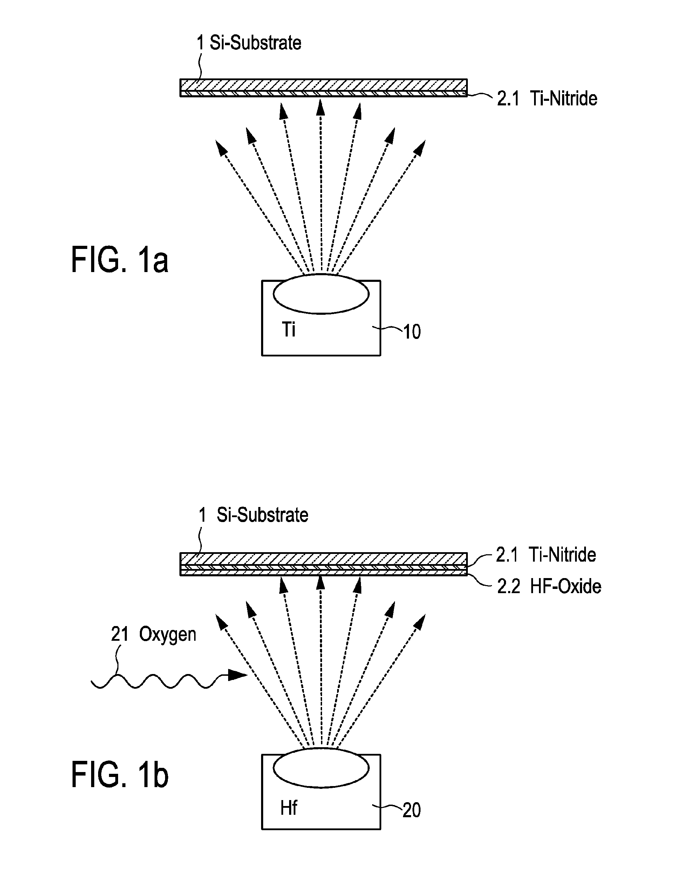

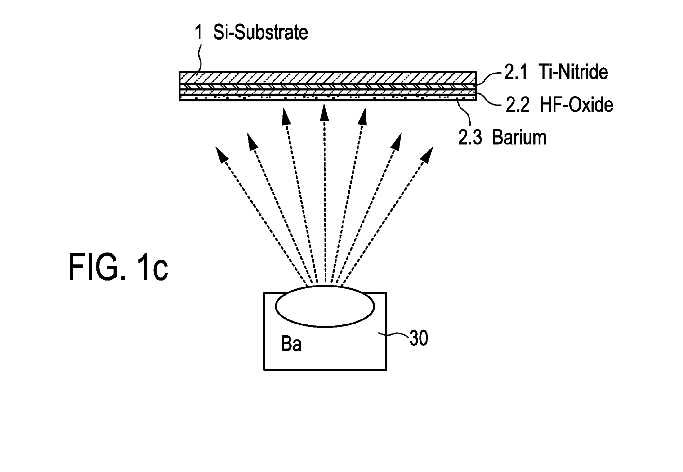

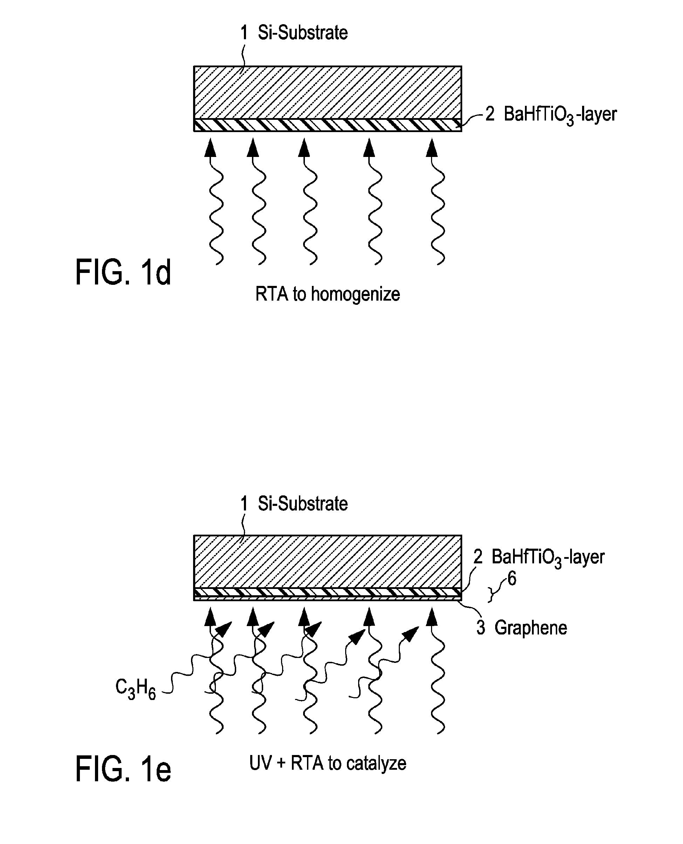

Fig. 1 shows schematically process steps (a) through (e) of a method of producing a capacitant semiconductor component having a silicon containing layer 1 in form of an (001) silicon substrate, a graphene layer 3 and a functional layer 2 sandwiched between the silicon substrate and the graphene layer 3 as shown in step (e). Therein the graphene layer 3 has been directly deposited on the functional layer 2 and the functional layer 2 has been directly deposited on the silicon substrate. Presently in step (a) to (c) TiN (with k=80), $HfO_2$ (with k=17) and Ba is deposited subsequently to form at first a surfactant functional layer stack of dielectric material with a dielectric constant k of approximately k=80 on the silicon substrate. Subsequent to transformation of the functional layer stack to a single functional layer 2 in step (d) the graphene layer 3 is deposited directly on the functional layer 2 in step (e) to form a double layer system 6. The conductance of the functional layer 2 in the double layer system 6 showed up to be below a conductance of the graphene layer 3. Consequently the semiconductor component produced with the processing steps of Fig. 1 showed up to provide a well working element for a semiconductor device.

In detail as shown in Fig. 1(a) a silicon containing layer 1 is provided in form of a silicon (001)-substrate covered by TiN as an adhesion layer. Using a solid state source 10 of Ti by means of MBE a TiN layer is deposited on the silicon containing layer 1. The TiN layer forms basically an adhesion layer 2.1 within the functional layer stack deposited directly on the silicon containing layer 1. On the adhesion layer 2.1 as shown in Fig. 1(b) a further functional layer of HfO is deposited from the solid state source 20 of Hafnium in an oxygen atmosphere 21. As a result in the process step of Fig. 1(b) on the adhesion layer 2.1 a HfO layer is deposited as a catalytic layer 2.2 of the functional layer stack. The catalytic layer 2.2 is deposited directly on the adhesion layer 2.1. In the present embodiment oxidation of Hafnium serves to reduce the catalytic reactivity of Hafnium as such. Consequently in the present case oxidation of Hafnium serves to provide a sub maximal catalytic activity. This measure allows to provide a sensitive compromise catalytic activity of the functional layer 2 transformed from the functional layer stack. This allows to catalytically crack C atoms from a precursor gas $C_3H_6$ as shown in Fig. 1(e). On the other hand the catalytic activity of the resulting HfO layer of the functional layer 2 in the functional layer stack is below maximum for providing a surfactant-surface with weak binding properties as a basis for depositing a graphene layer 3.

As shown in Fig. 1(c) from further solid state source 30 of Barium a Ba layer is deposited as a third surfactant layer 2.3 in the functional layer stack. Thereby a fine tuning of the reactivity of the functional layer 2 in relation to the deposition of graphene is provided. In particular Van-der-Waals-like weak forces are allowed to be predominant on the surface of the surfactant functional layer 2 as conditioned by the surfactant layer 2.3 of Barium.

As shown in Fig. 1(d) the functional layer stack with flayers 2.1, 2.2 and 2.3 is subject to a homogenising step by means of a rapid thermal annealing (RTA) process. Therein, with slightly raised temperature, a well homogenised $BaHfTiO_3$ layer is formed as a single functional layer 2 from the former functional layer stack of Fig.1(c). Thereon graphene can be deposited directly via the process step shown in Fig. 1(e).

The so called hard tuned buffer in form of the functional layer 2 turns out to have a good compromise conductance property between insulating and metallic conductance of the buffer. In the present embodiment the functional layer $BaHfTiO_3$ is made of about K=80 dielectric material wherein catalytic reactivity is reduced to gain semiinsulating Van-der-Waals-like weak reactivity for depositing a graphene layer 3 in a further process step.

The process step of Fig. 1(d) is a so called soft tuning of the buffer in form of the functional layer stack 2 wherein presently by RTA a layer homogenisation took place further sensitively tuning the functional layer stack 2 between insulating and metallic conductance properties; presently this can also be achieved by radiation, voltage appliances or further temperature steps in alternative embodiments. In particular a soft-tuning processing step selected from the group of steps consisting of:

- applying an elevated temperature,
- applying a voltage,
- applying UV-radiation;

for tuning a metal-isolator transition of the functional layer 2 is possible.

As shown in Fig. 1(e) graphene is deposited in a graphene layer 3 using a precursor gas $C_3H_6$ under UV-radiation. The UV-radiation either helps to switch the insulating properties of $BaHf_{1-x}Ti_xO3$ to metallic to improve the catalytic ability during growth and also helps to crack C-atoms from the $C_3H_6$ precursor gas to be provided already in a fractional ring configuration. The fractional ring configuration of C-atoms coordinate on the functional layer stack surface $BaHfTiO_3$ by forming Van der Waals-like bindings to the surface. The double layer system 6 exhibits extraordinary mobility and conductance properties.

Fig. 2 shows a further embodiment of a producing method with using lift off technology process steps symbolized in pictures (a) through (e) of Fig. 2.

As shown in Fig. 2(a) a resist 40 is deposited on a silicon containing layer 1 in form of a Si (111)-substrate. The resist 40 is processed during illumination by UV and the illuminated gate parts 41, 42 of the resist 40 are removed thereafter by etching.

As shown in Fig. 2(b) Praseodymium is deposited on the resist and in the corresponding gate trenches 41, 42 thereafter.

As shown in Fig. 2(c) after removing the resist 40 by etching an oxidation 21 of the gate parts 41, 42 to $Pr_2O_3$ builds a single functional layer 2' of $Pr_2O_3$. The functional layer 2' of dielectric material $Pr_2O_3$ with k=20 shows up to have a sufficiently suitable weak binding forces at the surface and also sufficient catalytic properties to allow the epitaxial deposition of a graphene layer 3' on top of the functional layer 2'. Presently Pr and graphene have been deposited by means of MBE. Fig. 2(c) shows that graphene layer 3' deposition by MBE deposition of C and subsequent annealing allows the formation of C on the surface of $Pr_2O_3$ to build up a homogenous and continuously covering graphene layer 3' on top of the functional layer 2'.

As shown in Fig. 2(d) and Fig. 2(e) the contacts of functional layer 2' are embedded in $SiO_2$ and subsequently the source and drain contacts 101, 102 are deposited on the double layer system formed by the functional layer 2' and the graphene layer 3'. With the source 101 and drain 102 contact the double layer system forms a gate 103 of the transistor device in Fig. 2(e). In the transistor device 100 the double layer system 6' of $Pr_2O_3$ functional layer 2' and graphene layer 3' forms a gate contact capacitance 103 of extraordinary mobility and conductance properties.

Fig. 3 shows a third embodiment of forming -again a MOSFET- transistor using a selective epitaxy to provide the basis structure shown in Fig. 3(a). Therein a silicon substrate 1 is used to embed a metal gate 5 in $SiO_2$ 4. Directly on the metal gate 5 a La-Perovskit functional layer 2" is deposited. Thereafter an amorphous layer 3A of C is deposited and due to the catalytic weak forces provided on the La-Perovskit functional layer 2" only in the area of the La-Perovskit functional layer 2" the C-atoms reformate on the surface to build a homogenous, crystalline and continuously covering graphene layer 3". The amorphous C layer 3A is highly resistive on the $SiO_2$ and can remain as it is or can be removed from the $SiO_2$ layer 4.

As shown in Fig. 3(b) finally source add drain contacts 201, 202 are deposited in contact to the graphene layer 3" thereby forming a transistor device 200 with a gate contact capacitance 203 formed by the double layer system 6" of graphene layer 3" and La-Perovskit functional layer 2" on the metal gate 5 with extraordinary mobility and conductance properties.

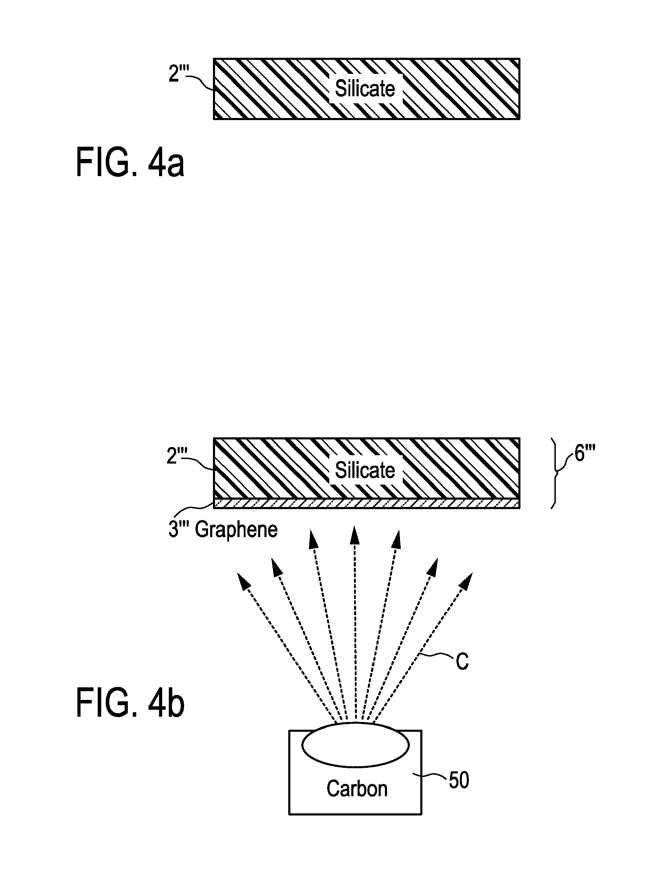

Fig. 4 shows a method of producing a semiconductor component in form of a double layer system 6'" of a graphene layer 3'" and a silicon containing substrate which presently also serves as a single surfactant functional layer 2'". This is achievable due to the extraordinary advantageous properties of the mica material in form of muscovite, namely presently selected as a $KAl_2(AlSi_3O_{10})(F,OH)$ silicate composition. The dielectric constant of the silicate composition is in between k=4 and k=12 and therefore, exhibits extraordinary advantageous weak forces for binding a graphene layer directly to the silicate. However, in the present embodiment as an alternative C is provided directly by a carbon source 50.

In detail, the process steps of the producing method are shown in (a) and (b) of Fig. 4. In a first step a silicate substrate 2'" composed of $KAl_2(AlSi_3O_{10})(F,OH)$ is provided. The silicate in the present form is hexagonal oriented and therefore provides additional to the surfactant weak binding forces and a structural preferable information for growth of graphene. As shown in (b) of Fig. 4C is provided from a carbon source 50 in an MBE like process step and is directly deposited on the silicate substrate 2'" as one or more graphene layers 3'". The MBE like step (b) of Fig. 4 is processed at elevated temperature, which are selected suitable for beaming the C to the silicate structured substrate and also allow suitable homogeneous distribution of the C atoms on the surface of the silicate substrate for formation of a homogenous graphene layer.

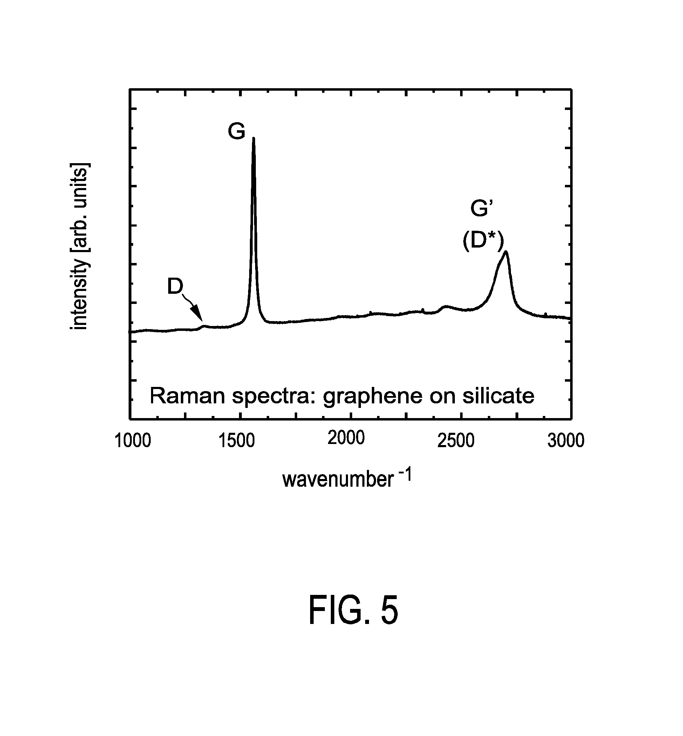

As proved by the Raman spectra shown in Fig. 5, the G and G' peaks indicate clearly the existence of graphene as described with Fig. 4 in the semiconductor component. The weak D peak shows a graphene layer with a high structural order.

In summary, various embodiments have been described for providing a semiconductor component comprising a silicon containing layer 1, at least one graphene layer 3, 3', 3", 3'" and functional layer 2, 2', 2", 2'" between the silicon containing layer 1 and the graphene layer 3, 3', 3", 3'", wherein the at least one graphene layer 3, 3', 3", 3'" is deposited directly on the functional layer 2, 2', 2", 2'" to form a double layer system 6, 6', 6", 6'" with the functional layer 2, 2', 2", 2'" and the functional layer 2, 2', 2", 2'" includes at least one dielectric material having a dielectric constant K in a range in between k=3 to k=1000, in particular between k=3 to k=400, and a conductance of the functional layer 2, 2', 2", 2'" in the double layer system 6, 6', 6", 6'" is below a conductance of the graphene layer 3, 3', 3", 3'". Also various methods of production have been described therewith.

## Claims

1. Semiconductor component comprising:

   - a silicon containing layer (1),
   - at least one graphene layer (3, 3', 3", 3'"), and
   - a functional layer (2, 2', 2", 2'") between the silicon containing layer (1) and the graphene layer (3, 3', 3", 3'"), wherein

   the at least one graphene layer (3', 3", 3'") is deposited directly on the functional layer (2, 2', 2", 2'") to form a layer system (6, 6', 6", 6'") with the functional layer (2, 2', 2", 2'"), and

   the functional layer (2, 2', 2", 2'") includes at least one dielectric material having a dielectric constant k in a range between K=3 to K=1000, in particular in a range between K=3 to K=400, and

   a conductance of the functional layer (2, 2', 2", 2'") in the layer system (6, 6', 6", 6'") is below a conductance of the graphene layer (3, 3', 3", 3'").

2. Semiconductor component according to claim 1 **characterized in that** the functional layer (2, 2', 2", 2'") is formed from a layer stack, the layer stack including an adhesion layer (2.1), in particular directly deposited on the silicon containing layer (1); and/or

   including a catalytic layer (2.2), in particular directly deposited on an adhesion layer; and/or

including a surfactant- and/or seed-layer (2.3), in particular directly deposited on a catalytic layer.

3. Semiconductor component according to claim 1 or 2 **characterized in that** the functional layer (2, 2', 2", 2''') consists of a single layer including the dielectric material and/or a layer stack is transformed to establish a single layer including the dielectric material.

4. Semiconductor component according to any of the claims 1 to 3 **characterized in that** the silicon containing layer (1) is a silicon substrate, in particular a Si(001)- or Si(111)-substrate.

5. Semiconductor component according to any of the claims 1 to 4 **characterized in that** the silicon containing layer (1) is a sheet silicate mineral substrate, in particular silicate of the mica-group, in particular selected from the group of mica substrates consisting of: phlogopite, biotite, zinnwaldite, lepidolite, muscovite.

6. Semiconductor component according to any of the claims 1 to 5 **characterized in that** the dielectric material of the functional layer (2, 2', 2", 2''') is an oxide or nitride or silicid or nitrate or silicate of an element selected from: an alkaline or an alkaline earth or a rare earth or a transition metal; or mixtures thereof.

7. Semiconductor component according to any of the claims 1 to 6 **characterized in that** the dielectric material of the functional layer (2, 2', 2", 2''') is an oxide or nitride or silicid or nitrate or silicate of an element selected from: Pr, Ce or Hf, Zr, Ti or Ba, Sr or Fe, Al, Mg, K or Ga, In, S, Se; or mixtures thereof.

8. Semiconductor component according to any of the claims 1 to 7 **characterized in that** the dielectric material of the functional layer (2, 2', 2", 2''') is a La-Perovskit or a chalkogenide or mixtures thereof.

9. Semiconductor component according to any of the claims 1 to 7 **characterized in that** the dielectric material of the functional layer (2, 2', 2", 2''') is a Ceriumoxide or a Praseodymiumoxide or a Hafniumoxide or mixtures thereof.

10. Semiconductor component according to any of the claims 1 to 9 **characterized in that** the dielectric material of the functional layer (2, 2', 2", 2''') is a sheet silicate mineral material, in particular silicate of the mica-group, in particular selected from the group of mica materials consisting of: phlogopite, biotite, zinnwaldite, lepidolite, muscovite.

11. Semiconductor component according to any of the claims 1 to 10 **characterized in that** a lattice of the functional layer (2, 2', 2", 2''') is of crystalline structure, in particular hexagonal or cubic structure.

12. Semiconductor component according to any of the claims 1 to 11 **characterized in that** the functional layer (2, 2', 2", 2''') has an EOT-value (equivalent oxid thickness) defined by the functional layer thickness multiplied by the dielectric constant K of the dielectric material of the functional layer (2, 2', 2", 2''') and wherein the functional layer EOT-value equals approximately the EOT-value of $SiO_x$ wherein $0 \leq x \leq 2$ and wherein a $SiO_x$-thickness is in the range between 0.5nm and 20nm.

13. Method of producing a semiconductor component, comprising the steps of:

- providing a silicon containing layer (1);
- depositing a functional layer (2, 2', 2", 2''') on the silicon containing layer (1) by one or more functional layer-depositing steps, wherein at least one dielectric material having a dielectric constant K in between K=3 to K=400 is deposited;
- directly depositing at least one graphene layer (3, 3', 3", 3''') on the functional layer (2, 2', 2", 2''') by one or more graphene layer-depositing steps to form a layer system consisting of the functional layer (2, 2', 2", 2''') and the graphene layer (3, 3', 3", 3'''), wherein a conductance of the functional layer (2, 2', 2", 2''') is below a conductance of the graphene layer (3, 3', 3", 3''').

14. Method according to claim 13 **characterized in that** the functional layer-depositing steps comprise one or more of the steps selected from:

- depositing an adhesion layer (2.1), in particular directly on the silicon containing layer (1);
- depositing a catalytic layer (2.2), in particular directly on an adhesion layer;
- depositing a surfactant- and/or seed-layer (2.3).

**15.** Method according to any of the claims 13 to 14 **characterized in that** the functional layer-depositing steps comprise:

a soft-tuning processing step selected from the group of steps consisting of:

- applying an elevated temperature,
- applying a voltage,
- applying UV-radiation;

for tuning a metal-isolator transition of the functional layer (2, 2', 2'', 2''').

1 Si-Substrate

2.1 Ti-Nitride

FIG. 1a

Ti 10

1 Si-Substrate

2.1 Ti-Nitride
2.2 HF-Oxide

21 Oxygen

FIG. 1b

Hf 20

1 Si-Substrate

2.1 Ti-Nitride

2.2 HF-Oxide

2.3 Barium

FIG. 1c

Ba

30

1 Si-Substrate

2 BaHfTiO₃-layer

FIG. 1d

RTA to homogenize

1 Si-Substrate

2 BaHfTiO₃-layer

6

3 Graphene

C₃H₆

FIG. 1e

UV + RTA to catalyze

FIG. 2a

deposit resist and light exposure

FIG. 2b

remove light developed resist
deposit Praseodymium layer

FIG. 2c

oxidize Pr
deposit graphene
etch Pr

2'  3'

6'

SiO₂

FIG. 2d

1

SiO₂(TEOS) fill up
CMP planarize

100

101 source

102 drain

103 gate

6'

SiO₂

FIG. 2e

1

S/D contacts

2" La-Perovskite

3" Graphene        C

amorph ↓↓↓↓↓↓↓↓↓↓↓↓↓↓↓↓↓↓↓↓↓↓↓↓↓↓↓↓↓↓↓↓↓↓↓

3A Carbon

4 SiO₂

**FIG. 3a**

1

prepared Substrate (back-gate)
La-Perovskite developed graphene

5 metal gate

2" La-Perovskite

3" Graphene

203          200

201 source          202 Drain

6"

4 SiO₂

**FIG. 3b**

1

Contacting Source-Drain

5 metal gate

FIG. 4a

FIG. 4b

FIG. 5

**Europäisches Patentamt**
**European Patent Office**
**Office européen des brevets**

## EUROPEAN SEARCH REPORT

Application Number

EP 10 16 7703

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | US 2010/028681 A1 (DAI HONGJIE [US] ET AL) 4 February 2010 (2010-02-04) * paragraph [0089]; figure 8 * ----- | 1-15 | INV. H01L29/786 |
| X | WO 2008/156583 A1 (HARVARD COLLEGE [US]; GORDON ROY G [US]; FARMER DAMON B [US]) 24 December 2008 (2008-12-24) * paragraphs [0037], [0038], [0048], [0089] * ----- | 1,2 | |
| A | US 2005/212014 A1 (HORIBE MASAHIRO [JP] ET AL) 29 September 2005 (2005-09-29) * paragraph [0040]; figure 5C * ----- | 5-12 | |
| A | WO 2010/036210 A1 (UNIV SINGAPORE [SG]; OEZYILMAZ BARBAROS [SG]; ZHENG YI [SG]; NI GUANG) 1 April 2010 (2010-04-01) * page 4, line 26 - line 32; figure 1A * ----- | 5-12 | |
| | | | TECHNICAL FIELDS SEARCHED (IPC) |
| | | | H01L |

The present search report has been drawn up for all claims

| Place of search | Date of completion of the search | Examiner |
|---|---|---|
| Berlin | 22 September 2010 | Juhl, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 10 16 7703

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2010

| Patent document cited in search report | | Publication date | Patent family member(s) | | Publication date |
|---|---|---|---|---|---|
| US 2010028681 | A1 | 04-02-2010 | NONE | | |
| WO 2008156583 | A1 | 24-12-2008 | NONE | | |
| US 2005212014 | A1 | 29-09-2005 | JP | 2005285822 A | 13-10-2005 |
| WO 2010036210 | A1 | 01-04-2010 | NONE | | |

EPO FORM P0459

For more details about this annex : see Official Journal of the European Patent Office, No. 12/82

**REFERENCES CITED IN THE DESCRIPTION**

**Patent documents cited in the description**

- US 20080246023 A1
- DE 102008055100
- EP 2009066958 W

**Non-patent literature cited in the description**

- **P. R. WALLACE et al.** The Band Theory of Graphite. *PR,* 1947, vol. 71, 622-634
- **BANERJEE et al.** *APL,* 2006, vol. 88, 062111
- **KIM et al.** *Nature,* 2009, vol. 457, 706-710
- **REINA et al.** *NanoRes,* 2009, 509-516
- **QUINGKAI et al.** *APL,* 2008, vol. 93, 113103
- **LIANG et al.** *JAP,* 2007, vol. 102, 054307
- **ZHANG et al.** *IEEE Electron Device Letters,* 2008, 0741-3106